(19) Europäisches Patentamt
European Patent Office
Office européen des brevets

(11) **EP 1 274 089 B1**

(12) **EUROPÄISCHE PATENTSCHRIFT**

(45) Veröffentlichungstag und Bekanntmachung des Hinweises auf die Patenterteilung:
**10.01.2007  Patentblatt 2007/02**

(51) Int Cl.:
*H01L 43/02* *(2006.01)*

(21) Anmeldenummer: **02015043.9**

(22) Anmeldetag: **05.07.2002**

(54) **GMR-Modul**

GMR module

Module GMR

(84) Benannte Vertragsstaaten:
**AT BE BG CH CY CZ DE DK EE ES FI FR GB GR IE IT LI LU MC NL PT SE SK TR**

(30) Priorität: **07.07.2001  DE 10133123**

(43) Veröffentlichungstag der Anmeldung:
**08.01.2003  Patentblatt 2003/02**

(73) Patentinhaber: **AB Elektronik GmbH**
**59368 Werne (DE)**

(72) Erfinder: **Apel, Peter**
**59394 Südkirchen (DE)**

(74) Vertreter: **Wenzel & Kalkoff**
**Postfach 24 48**
**58414 Witten (DE)**

(56) Entgegenhaltungen:
**EP-A- 1 054 237          DE-A- 10 023 695**
**US-A- 3 781 750          US-A- 3 852 103**

- **CLEMENS W ET AL: "Contactless potentiometer based on giant magnetoresistance sensors" JOURNAL OF APPLIED PHYSICS, AMERICAN INSTITUTE OF PHYSICS. NEW YORK, US, Bd. 81, Nr. 8, 15. April 1997 (1997-04-15), Seite 4310, XP012042042 ISSN: 0021-8979**

EP 1 274 089 B1

**Beschreibung**

Die Erfindung betrifft ein Bauelement, insbesondere eine Giant-Magneto-Resistor-Einrichtung, bestehend aus wenigstens

- einer Bauelement-Zelle, die wenigstens zwei Anschlußelemente aufweist, die in einem Funktionsanschlußelement enden
- wobei an den Anschlußelementen zwischen der Bauelement-Zelle und dem Funktionsanschlußelement eine Mäandergruppe mit wenigstens einem Mäanderelement angeordnet ist.

Ein Giant-Magneto-Resistor-(GMR-)Modul weist eine GMR-Zelle mit zwei im wesentlichen geraden Anschlußelementen auf.

Insbesondere bei einer Verbindung der geraden Anschlußelemente mit anderen Teilen und Elementen eines Gesamtsystems kann das Bauelement Kräften ausgesetzt werden, die zu einer Zerstörung der Verbindungen oder von Teilen des Bauelements führen kann. Da die GMR- Zelle geometrisch relativ klein ist, kann sie als das eigentliche aktive Element von der Zerstörung als erste betroffen sein.

In der DE 100 23 695 A ist eine Verstellvorrichtung für eine Drosselklappeneinheit beschrieben. Diese verfügt über einen Drehsensor, dessen Statorteil an einem aus Kunststoff gebildeten Gehäuseelement angeordnet ist. Das Statorteil verfügt über Hall-Einheiten, die über Leiterzüge eines Stanzgitters mit Steckerkontakten verbunden sind. Am Stanzgitter sind Bauelemente angeordnet. Beim Formen des Gehäuseelements werden das Stanzgitter und die Bauelemente wenigstens teilweise von dem Kunststoff umschlossen.

In der EP 1054 237 A ist ein Hall-Effekt-Drehwinkelsensor gezeigt. Im Deckelement eines Drosselklappengehäuses sind hierbei Hall-Sensoren vorgesehen, die mit einer Steckereinheit über ein Stanzgitter verbunden sind. Es ist angegeben, dass auf dem Stanzgitter Bauelemente angeordnet sein können. Das Statorelement, die Stanzgitter und die Bauelemente werden bei der Formung des Deckelements aus Kunststoff mit eingeformt.

Die US 3,281,750 A zeigt ein Bauelement. Ein Halbleiterelement (Magnetwiderstand) weist mehrere Elektroden auf, an denen flache Leiterzüge (Leadframes) angebracht sind. Um mechanische Kräfte zu vermeiden, weisen die Leiterzüge Mäander-Abschnitte auf, die so geformt sind, dass sie eine durchgehende flache Oberfläche haben, die sich abwechselnd in entgegengesetzte Richtungen windet.

Es ist Aufgabe der Erfindung, ein Bauelement, insbesondere eine Giganto-Magneto-Resistor-(GMR) Einrichtung vorzuschlagen, bei dem sowohl eine vorteilhafte mechanische als auch elektrische Funktion gegeben ist.

Erfindungsgemäß wird die Aufgabe gelöst durch ein Bauelement gemäß Anspruch 1. Abhängige Ansprüche beziehen sich auf bevorzugte Ausführungsformen der Erfindung.

Die Erfindung sieht vor,

- daß an den beiden Anschlußelementen zwischen der Bauelement-Zelle und dem Funktionsanschlußelement eine Mäandergruppe mit wenigstens einem Mäanderelement angeordnet ist und
- daß auf der Mäandergruppe des ersten Anschlußelements und auf der Mäandergruppe des zweiten Anschlußelements eine Kondensatoreinheit angeordnet ist.

Die mit der Erfindung erzielten Vorteile bestehen insbesondere darin, daß durch die Mäandergruppen eine mechanische Entkopplung entsteht. Diese mechanische Entkopplung entsteht zum einen in den Anschlußelementen und zum anderen zwischen den Anschlußelementen. Dadurch wird die mechanische Belastung vor allen der GMR-Einheit vermieden. Hierdurch wird die Entstehung von Rissen verhindert. Die einzelnen Mäanderelemente der Mäandergruppen in den Anschlußelementen nehmen vor allem die entstehenden Längenänderungen, die sich bei einer Temperaturbelastung zwischen minus 40° und plus 160° in einem Fahrzeug ergeben können.

Die Kondensatoreinheit kann auf der Mäandergruppe des ersten und zweiten Anschlußelements aufgeschweißt werden. Die Schweißverbindung stellt eine sehr effektive und kostengünstige Verbindung dar.

Die Mäanderelemente können rechteck-, sinus- oder sägezahnförmig oder in einer Kurvenform einer gedämpften Schwingung ausgebildet sein. Im Prinzip bewirken sämtliche geschlängelten Formen der Mäanderelemente die gleiche mechanische Entkopplung, wie die rechteckig, sinusförmig oder dgl. ausgebildeten Mäanderelemente. Die Mäanderelemente können auch als geschlitzte und gezogene Blechelemente ähnlich einem Streckmetallelement ausgebildet sein. Auch sie sind in der Lage, eine mechanische Entkopplung zu realisieren.

Zwischen der Mäandergruppe und der Bauelement-Zelle in dem ersten und dem zweiten Anschlußelement kann ein Dehnungsschleifenelement angeordnet sein. Das Dehnungsschleifenelement kann treppenförmig ausgebildet sein. Das Dehnungsschleifenelement kann auch wie eine Dehnungsschleife einer Rohrleitung ausgebildet sein. Das Dehnungsschleifenelement trägt zum einen zu einer weiteren mechanischen Entkopplung bei. Darüber hinaus sichert es die lagegerechte Verbindung zwischen der Bauelement-Zelle und der Kondensatoreinheit. Es sei an dieser Stelle bemerkt, daß anstelle einer Kondensatoreinheit auch eine Widerstandseinheit oder eine andere Baueinheit eines passiven Bauelements eingesetzt werden kann.

Die beiden Anschlußelemente können rechteck-, dreieck- oder kreisförmig oder dgl. ausgebildet sein.

Welche Form der Anschlußelemente zum Einsatz kommt, hängt von den jeweiligen Einbau- und Fertigungsbewegungen ab.

Die Bauelement-Zelle kann eine Giant-Magneto-Resistor-Zelle sein. Die Bauelement-Zelle kann auch eine Zelle sein, die ein anders ausgebildetes Bauelement enthält.

Die Giant-Magneto-Resistor-Zelle kann ein Halbleiterstreifen mit Nadeln und/oder kurzschließenden Rastern aufweisen. Sie kann aber auch anders ausgebildet sein.

Ein Ausführungsbeispiel der Erfindung ist in der Zeichnung dargestellt und wird im folgenden näher beschrieben. Es zeigen:

Fig. 1    ein GMR- Modul in einer schematisch dargestellten Draufsicht und

Fig. 2    ein GMR- Modul gemäß Fig. 1 in einer schematisch dargestellten Seitensicht.

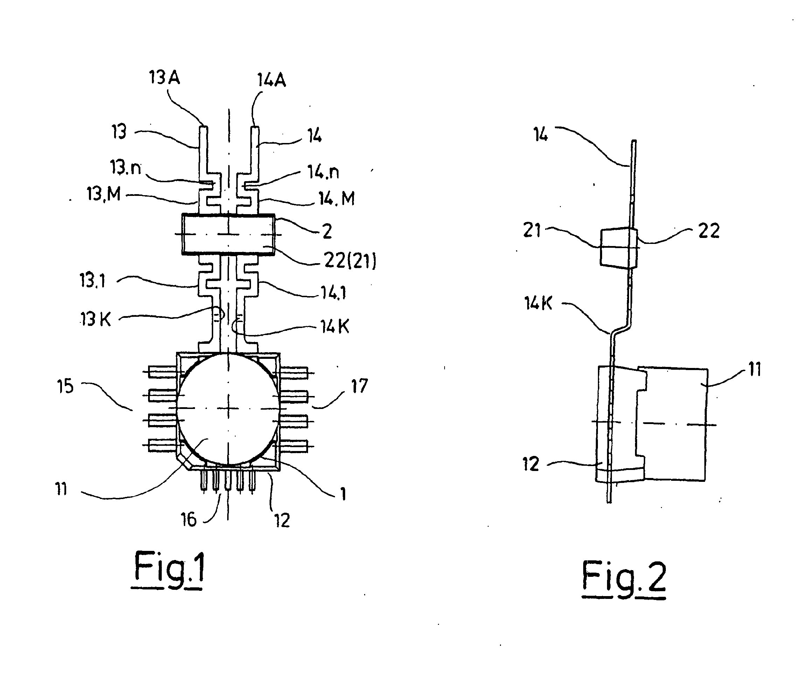

Ein GMR-Modul besteht, wie die Fig. 1 und 2 zeigen, aus

-    einer Giant-Magneto-Resistor-(GMR-)Zelle 1 und
-    einer Kondensatoreinheit 2.

Die GMR-Zelle 1 weist ein GMR-Gehäuseelement 12 auf, auf dem ein GMR-Element angeordnet ist. Das GMR-Element ist ein magnetischer Widerstand, der Reluktanz $R_m$. Bei einem magnetischen Kreis ist die Reluktanz der Quotient aus der magnetischen Spannung V und dem im Kreis vorhandenen magnetischen Fluß $\varphi$, d.h.

$$R_m = \frac{V}{\varphi}$$

Der Kehrwert des magnetischen Widerstands wird magnetischer Leitwert $\Lambda$ genannt.

Der magnetische Widerstand oder auch Magneto-Widerstand (Feldplatte) genannt, wird zur Erzielung hoher Signalspannungen bei gleichzeitig kleinen Strömen eingesetzt. Bei diesem Bauelement ist man bestrebt, die relative Widerstandsänderung möglichst groß zu machen und diese Widerstände auf kleinster Fläche zu realisieren.

Der Hall-Effekt, der bei der Erzielung großer Widerstandsänderungen im Magnetfeld stört, kann nahezu eliminiert werden, wenn in den InSb-Kristall (eigenleitend bzw. dotiert) InSb-Nadeln eingelagert werden oder auf dem homogenen InSb-Kristall ein kurzschließendes Raster angebracht wird. Eine andere Möglichkeit, den Hall-Effekt auszuschließen, ist die Verwendung einer runden, in der Mitte und am Rand kontaktierten Scheibe (corbinodisk).

Vom GMR-Gehäuse-Element 12 gehen zwei im wesentlichen parallel zueinander laufende Anschlußelemente 13, 14 ab.

Direkt hinter dem GMR-Gehäuse-Element ist in beide Anschlußelemente ein Dehnungsschleifenelement 13K, 14K eingebracht. Das Dehnungschleifenelement kann im wesentlichen treppenförmig ausgebildet sein. Es kann auch Ω-förmig, V-förmig oder dgl. in die beiden Anschlußelemente eingeformt werden.

Nach dem Dehnungsschleifenelement ist in beide Anschlußelemente 13, 14 eine Mäandergruppe 13.n, 14.n aus einzelnen Mäanderelementen 13.1,..., 13.n, 14.1,...,14.n eingeformt.

Wie insbesondere Fig. 1 zeigt, sind die beiden Anschlußelemente aus einem Flachschienenmaterial hergestellt. In diese so ausgebildeten Anschlußelemente sind die einzelnen Mäanderelemente 13.1,...,14.1,... rechteckwellenförmig eingeformt. Jede Mäandergruppe weist sechs Mäanderelemente 13.1,... auf.

Nach den beiden so ausgebildeten Mäandergruppen 13M, 14M setzen sich die Anschlußelemente 13, 14 in einem gerade verlaufenden Funktionanschlußelement 13A fort. An die im wesentlichen linear ausgebildeten Funktionsanschlußelemente 13A, 14A wird ein Anschluß mit weiteren Bauelementen bzw. Schaltkreiseinheiten oder dgl. vorgenommen.

Auf den beiden gegenüberliegenden Mäandergruppen 13M, 14M der beiden Anschlußelemente 13, 14 ist die Kondensatoreinheit 2 angeordnet.

Die Kondensatoreinheit 2 weist ein Kondensator-Anschlußelement 12 auf, auf dem ein Kondensatorelement 21 angeordnet ist. Die Verbindung zwischen der Kondensatoreinheit 2 und den beiden Anschlußelementen erfolgt so, daß die Mäandergruppen 13M, 14M von dem Kondensator-Anschlußelement 12 und dem darüber liegenden Kondensatorelement 21 aufgenommen wird. Die Verbindung wird durch Schweißen vorgenommen.

Wie insbesondere Fig. 2 zeigt, ist das Dehnungschleifenelement 13K, 14K so ausgebildet, daß die Unterkante des GMR-Gehäuseelements 12 und die Unterkante des Kondensatorelements 21 in einer Ebene liegen. Hierdurch läßt sich das GMR-Modul lagegerecht installieren.

Das GMR-Gehäuse-Element 12 ist im wesentlichen rechteckförmig ausgebildet. An wenigstens einer der noch freien Seiten kann eine Anschlußgruppe angeordnet sein. In Fig. 1 sind an den drei freien Seiten eine Anschlußgruppe 15, eine Anschlußgruppe 16 und eine Anschlußgruppe 17 angeordnet.

Wird das GMR-Modul eingebaut, ist es thermischen Belastungen ausgesetzt. Die Einsatztemperaturen können zwischen minus 40 und plus 160°C betragen. Bei diesen extremen Temperaturdifferenzen verändern die Materialien ihre Lage und ihre Länge. Durch die Mäandergruppen 13M, 14M wird eine wirksame mechanische Entkopplung der sehr empfindlichen GMR-Zelle 1 vorgenommen. Dadurch, daß die einzelnen Mäanderelemente 13.1,..., 14.1,...die durch die Längenänderungen auftretenden Kräfte aufnehmen, wird die empfindliche GMR-Zelle geschützt. Hierdurch wird gesichert, daß sie in dem jeweiligen Schaltungsverbund sicher ihre Funktion ausüben kann.

**Patentansprüche**

1. Bauelement, insbesondere Giant-Magneto-Resistor-Einrichtung, bestehend aus wenigstens

   - einer Bauelement-Zelle (1), die wenigstens zwei Anschlußelemente (13, 14) aufweist, die in einem Funktionsanschlußelement (13A, 14A) enden,
   - wobei an den beiden Anschlußelementen (13, 14) zwischen der Bauelement- Zelle (1) und dem Funktionsanschlußelement (13A, 14A) eine Mäandergruppe (13M, 14M) mit wenigstens einem Mäanderelement (13.1,...,13.n, 14.1,..., 14.n) angeordnet ist,

   **dadurch gekennzeichnet, daß**

   - eine Kondensatoreinheit (2) zwischen den beiden Anschlußelementen (13, 14) angeordnet ist,
   - die auf der Mäandergruppe (13M) des ersten Anschlußelements (13) und auf der Mäandergruppe (14M) des zweiten Anschlußelements (14) angeordnet ist.

2. Bauelement nach Anspruch 1, bei dem

   - die Funktionsanschlußelemente (13A, 14A) gerade sind.

3. Bauelement nach Anspruch 1 oder 2, **dadurch gekennzeichnet, daß** die Kondensatoreinheit (2) auf der Mäandergruppe (13M, 14M) des ersten und zweiten Anschlußelements (13, 14) aufgeschweißt ist.

4. Bauelement nach einem der vorhergehenden Ansprüche, **dadurch gekennzeichnet, daß** die Mäanderelemente (13.1,...,13.n, 14.1,..., 14.n) rechteck-, sinus- oder sägezahnförmig oder in einer Kurvenform einer gedämpften Schwingung ausgebildet ist.

5. Bauelement nach einem der vorhergehenden Ansprüche, **dadurch gekennzeichnet, daß** zwischen der Mäandergruppe (13M, 14M) und der Bauelement-Zelle (1) in dem ersten und dem zweiten Anschlußelement (13, 14) ein Dehnungsschleifenelement (13K, 14K) angeordnet ist.

6. Bauelement nach Anspruch 5, **dadurch gekennzeichnet, daß** jedes Dehnungsschleifenelement (13K, 14K) absatzförmig ausgebildet ist.

7. Bauelement nach einem der vorhergehenden Ansprüche, **dadurch gekennzeichnet, daß** die beiden Anschlußelemente (13, 14) rechteck-, dreieck- oder kreisförmig ausgebildet sind.

8. Bauelement nach einem der vorhergehenden Ansprüche, **dadurch gekennzeichnet, daß** die Bauelement-Zelle eine Giant-Magneto-Resistor-Zelle (1) ist.

9. Bauelement nach Anspruch 8, **dadurch gekennzeichnet, daß** die Giant-Magneto-Resistor-Zelle (1) Halbleiterstreifen mit Nadeln und/oder kurzschließenden Rastern aufweist.

**Claims**

1. A component, in particular a giant magneto-resistor element, comprising at least
   a component cell (1) comprising at least two connection elements (13, 14) ending in a functional connectivity element (13A, 14A) wherein a meandering assembly (13M ,14M) with at least one meandering element (13.1, ..., 13.n, 14.1, ..., 14.n) is arranged at the two connection elements (13, 14) between the component cell (1) and the functional connectivity element (13A, 14A),
   **characterised in that**
   a capacitor unit (2) is positioned between the two connection elements (13, 14),
   which is arranged on the meandering assembly (13M) of the first connection element (13) and on the meandering assembly (14M) of the second connection element (14).

2. The component according to claim 1, wherein the functional connectivity elements (13A, 14A) are straight.

3. The component according to claim 1 or 2, **characterised in that** the capacitor unit (2) is welded onto the meandering assembly (13M, 14M) of the first and second connection elements (13, 14).

4. The component according to any one of the preceding claims, **characterised in that** the meandering elements (13.1, ..., 13.n, 14.1, ..., 14.n) are rectangular, sinusoidal or sawtooth-shaped, or have a wave form of a damped vibration.

5. The component according to any one of the preceding claims, **characterised in that** an elongation loop element (13K, 14K) is arranged between the meandering assembly (13M, 14M) and the component cell (1) in the first
and second connection elements (13, 14).

6. The component according to claim 5, **characterised in that** each elongation loop element (13K, 14K) has a stepped shape.

7. The component according to any one of the preceding claims, **characterised in that** the two connection elements (13, 14) have a rectangular, triangular or circular configuration.

8. The component according to any one of the preceding claims, **characterised in that** the component cell is a giant magneto-resistor cell (1).

9. The component according to claim 8, **characterised in that** the giant
magneto-resistor cell (1) has semiconductor strips with pins and/or short-circuit grids.

**Revendications**

1. Composant, en particulier dispositif GMR (magnétorésistant géant), constitué par au moins

   - une cellule de composant (1) qui présente au moins deux éléments de branchement.(13, 14) qui se terminent dans un élément de branchement fonctionnel (13A, 14A),
   - un groupe en méandres (13M, 14M) avec au moins un élément en méandres (13.1,..., 13.n, 14.1, ..., 14.n) étant placé aux deux éléments de branchement (13, 14) entre la cellule de composant (1) et l'élément de branchement fonctionnel (13A, 14A),

   **caractérisé en ce**

   - **qu'**une unité de condensateur (2) est placée entre les deux éléments de branchement (13, 14)
   - qui est placée sur le groupe en méandres (13M) du premier élément de branchement (13) et sur le groupe en méandres (14M) du second élément de branchement (14).

2. Composant selon la revendication 1 pour lequel

   - les éléments de branchement fonctionnels (13A, 14A) sont droits.

3. Composant selon la revendication 1 ou 2, **caractérisé en ce que** l'unité de condensateur (2) est soudée sur le groupe en méandres (13M, 14M) du premier et du second élément de branchement (13, 14).

4. Composant selon l'une des revendications précédentes, **caractérisé en ce que** les éléments en méandres (13.1, ..., 13.n, 14.1, ..., 14.n) sont configurés rectangulaires, sinusoïdaux ou en dents de scie ou en une forme courbe d'une oscillation amortie.

5. Composant selon l'une des revendications précédentes, **caractérisé en ce qu'**un élément de boucle d'allongement (13K, 14K) est placé entre le groupe en méandres (13M, 14M) et la cellule de composant (1) dans le premier et le second élément de branchement (13, 14).

6. Composant selon la revendication 5, **caractérisé en ce que** chaque élément de boucle d'allongement (13K, 14K) est configuré en forme de palier.

7. Composant selon l'une des revendications précédentes, **caractérisé en ce que** les deux éléments de branchement (13, 14) sont configurés rectangulaires, triangulaires ou circulaires.

8. Composant selon l'une des revendications précédentes, **caractérisé en ce que** la cellule de composant est une cellule GMR (magnétorésistante géante) (1).

9. Composant selon la revendication 8, **caractérisé en ce que** la cellule GMR (magnétorésistante géante) (1) présente des bandes semi-conductrices avec des aiguilles et/ou des grilles court-circuitantes.

Fig.2

Fig.1

6